(19) Europäisches Patentamt / European Patent Office / Office européen des brevets

(11) **EP 2 991 225 A1**

(12) **DEMANDE DE BREVET EUROPEEN**

(43) Date de publication:
02.03.2016 Bulletin 2016/09

(51) Int Cl.:
*H03K 17/082* (2006.01)  *F02N 11/08* (2006.01)
*H03K 17/16* (2006.01)

(21) Numéro de dépôt: **15180249.3**

(22) Date de dépôt: **07.08.2015**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**MA**

(30) Priorité: **01.09.2014 FR 1458151**

(71) Demandeur: **VALEO EQUIPEMENTS ELECTRIQUES MOTEUR**
**94046 Créteil Cedex (FR)**

(72) Inventeur: **SARDAT, Pierre**
**93340 LE RAINCY (FR)**

(54) **RELAIS STATIQUE DE COMMANDE D'UN DÉMARREUR ÉLECTRIQUE DE VÉHICULE AUTOMOBILE ET DÉMARREUR ÉLECTRIQUE DE VÉHICULE AUTOMOBILE CORRESPONDANT**

(57) Le relais statique (1, 10, 18, 19) de commande d'un démarreur électrique (2) de véhicule automobile selon l'invention est du type de ceux comprenant en série dans un circuit d'alimentation électrique du démarreur, formant charge inductive, un premier commutateur à semi-conducteur de puissance (4) et au moins un second commutateur à semi-conducteur de puissance (11). Le premier commutateur et le second commutateur effectuent une opération de commutation. Le premier commutateur effectue en outre une opération de démagnétisation de la charge inductive et le second commutateur a en outre une fonction de sécurité. Conformément à l'invention, le second commutateur effectue en outre ladite opération de démagnétisation. Selon une autre caractéristique de l'invention, le premier commutateur effectue l'opération de démagnétisation au moyen d'un premier circuit de clampage actif (8) et le second commutateur effectue l'opération de démagnétisation au moyen d'un second circuit de clam page actif (31).

FIG. 5

EP 2 991 225 A1

**Description**

**DOMAINE TECHNIQUE DE L'INVENTION.**

La présente invention concerne un relais statique de commande d'un démarreur électrique de véhicule automobile, ainsi qu'un démarreur électrique de véhicule automobile comprenant un tel relais statique.

**ARRIERE PLAN TECHNOLOGIQUE DE L'INVENTION.**

Les véhicules automobiles à moteur thermique comportent classiquement un réseau électrique de bord comprenant une batterie, généralement de 12 V, destiné à alimenter en énergie électrique les divers équipements, notamment un démarreur électrique, indispensable pour assurer un démarrage du moteur thermique.

Compte tenu de l'intensité très importante d'un courant d'appel circulant dans le démarreur électrique en début de fonctionnement, la clé de contact commande le démarreur par l'intermédiaire d'un relais.

Ces relais ont été longtemps des relais de puissance électromagnétiques. Mais ces relais présentent de nombreux inconvénients, notamment:

- une durée de vie limitée à au maximum 20000 cycles d'ouverture/ fermeture sans charge, beaucoup moins en forts courants;
- une masse et un volume importants;
- un vieillissement des contacts conduisant à une très forte augmentation de la résistance des contacts avec le temps, passant par exemple de 0,5 à 10 mΩ;
- le bruit mécanique généré par la fermeture des contacts;
- le coût assez élevé.

La tendance depuis plusieurs années est donc de remplacer les relais de puissance électromagnétiques, ou certains de leurs éléments, par des relais de puissance à semi-conducteurs, dit "relais statiques", comme le montre par exemple la demande internationale WO200503177 de la société VALEO EQUIPEMENT ELECTRIQUE MOTEUR.

De nos jours, les semi-conducteurs de puissance de type MOSFET ont des performances suffisantes pour remplacer totalement un relais de puissance électromagnétique.

Toutefois, ces semi-conducteurs doivent présenter des caractéristiques leur permettant de supporter des surtensions produites par la commutation d'une charge inductive, telle qu'un moteur électrique de démarreur, et être correctement protégés par des circuits de protections adaptés, notamment par des circuits de clampage actif effectuant une opération de démagnétisation de la charge inductive.

Dans des relais statiques de commande d'un démarreur électrique de véhicule automobile comprenant plusieurs MOSFET en série, l'entité inventive a constaté que cette opération de démagnétisation n'était effectuée que par un seul MOSFET, entraînant surdimensionnement et surcoût.

**DESCRIPTION GENERALE DE L'INVENTION.**

La présente invention vise donc à pallier les inconvénients précités des relais statiques connus de l'état de la technique dans le domaine de l'automobile.

L'invention a précisément pour objet un relais statique de commande d'un démarreur électrique de véhicule automobile du type de ceux comprenant en série dans un circuit d'alimentation électrique de ce démarreur, formant charge inductive, un premier commutateur à semi-conducteur de puissance de type MOSFET et au moins un second commutateur à semi-conducteur de puissance de type MOSFET.

Dans ce type de relais statique, le premier commutateur et le second commutateur effectuent une opération de commutation, le premier commutateur effectuant en outre une opération de démagnétisation de la charge inductive et le second commutateur ayant en outre une fonction de sécurité.

Conformément à l'invention, le second commutateur effectue en outre cette opération de démagnétisation, le premier commutateur effectuant l'opération de démagnétisation au moyen d'un premier circuit de clampage actif et le second commutateur effectuant cette opération de démagnétisation au moyen d'un second circuit de clampage actif, et le premier circuit de clampage actif et le second circuit de clampage actif comprenant respectivement un premier pont diviseur de tension et un second pont diviseur de tension déterminant une tension de démagnétisation de la charge inductive, et

une première extrémité du premier pont diviseur de tension est reliée à une première source du premier commutateur alimentant la charge inductive par rapport à une masse, et une seconde extrémité du premier pont diviseur de tension est reliée à une première diode reliée à cette masse, un premier point milieu de ce premier pont diviseur de tension étant relié à des premières bases communes de premiers transistors bipolaires complémentaires ayant des premiers émetteurs communs connectés à une première grille du premier commutateur.

Selon l'invention également, une première borne du second pont diviseur de tension est reliée à une seconde source du second commutateur connectée à un premier drain du premier commutateur, et une seconde borne du second pont diviseur de tension est reliée à une seconde diode reliée à la masse. Un second point milieu du second pont diviseur de tension est relié à des secondes bases communes de seconds transistors bipolaires complémentaires ayant des seconds émetteurs communs connectés à une seconde grille du second commutateur.

Dans une variante du relais statique de commande d'un démarreur électrique de véhicule automobile selon l'invention, la première diode est en outre reliée à la masse par une diode Zener montée tête-bêche en série.

Le premier pont diviseur de tension et le second pont diviseur de tension présentent, dans cette variante, un même rapport prédéterminé.

Dans cette variante du relais statique de commande d'un démarreur électrique de véhicule automobile selon l'invention, le premier commutateur et le second commutateur présentent une même tension de seuil prédéterminée et une même transconductance prédéterminée, les premiers transistors bipolaires complémentaires et les seconds transistors bipolaires complémentaires présentent une même tension émetteur- collecteur prédéterminée. Le rapport prédéterminé est alors donné par la relation:

$$k = \frac{V_{GSth} + V_{be} + \dfrac{I_{D(Max)}}{g}}{V_{DZ} + R.I_{D(Max)} - Vbatt_{Max} - V_{D2}}$$

- $V_{GSth}$ étant la tension de seuil prédéterminée;
- $V_{be}$ étant la tension émetteur- base prédéterminée;
- g étant la transconductance prédéterminée;
- $V_{DZ}$ étant une tension Zener de la diode Zener;
- $V_{D2}$ étant une tension de coude de la seconde diode;
- $I_D$ étant une intensité maximale d'un courant circulant dans la charge inductive alimentée par une batterie d'une tension maximale égale à $Vbatt_{Max}$;
- R étant une résistance électrique du circuit d'alimentation électrique.

L'invention a également pour objet un démarreur de véhicule automobile comprenant un relais statique ayant les caractéristiques décrites ci-dessus.

Ces quelques spécifications essentielles auront rendu évidents pour l'homme de métier les avantages apportés par l'invention par rapport à l'état de la technique antérieur.

Les spécifications détaillées de l'invention sont données dans la description qui suit en liaison avec les dessins ci-annexés.

Il est à noter que ces dessins n'ont d'autre but que d'illustrer le texte de la description et ne constituent en aucune sorte une limitation de la portée de l'invention.

**BREVE DESCRIPTION DES DESSINS.**

Les **Figure 1a, 1b, 1c et 1d** montrent schématiquement quatre solutions de démagnétisation d'une charge inductive commutée connues de l'état de la technique.

La **Figure 2** montre schématiquement un relais statique avec plusieurs transistors à effet de champ de type MOSFET en série, connu de l'état de la technique, comportant un seul circuit de clampage actif.
La **Figure 3** montre schématiquement un circuit de clampage actif selon l'invention.
Les **Figures 4 et 5** montrent schématiquement un relais statique selon l'invention comprenant deux exemplaires du circuit de clampage actif montré sur la **Figure 3,** et, respectivement, une variante.

**DESCRIPTION DES MODES DE REALISATION PREFERES DE L'INVENTION.**

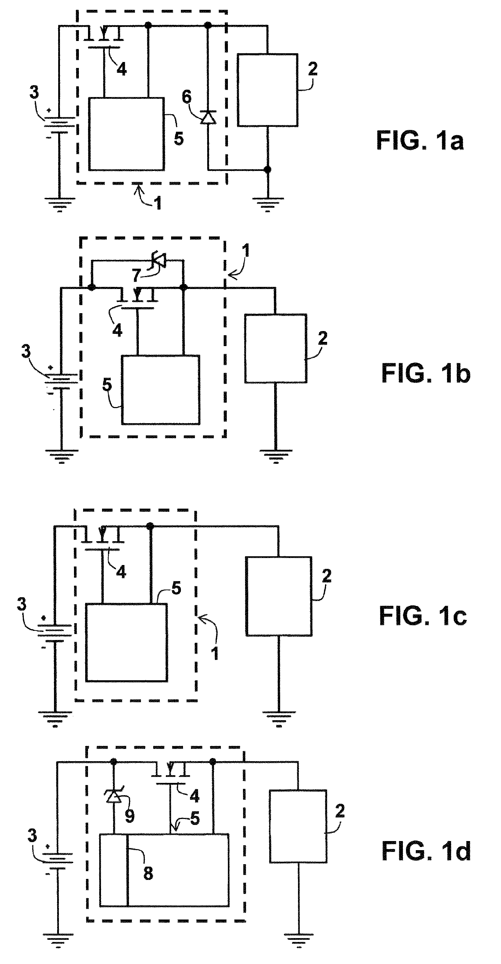

Un rappel, en liaison avec les **Figures 1a, 1b, 1c et 1d,** des solutions connues de démagnétisation quand un relais statique 1 est utilisé pour commuter la charge inductive formée par un démarreur 2 permettra de bien comprendre l'apport de l'invention.

Dans un relais statique 1 de démarrage, l'intensité du courant d'alimentation fournie par la batterie 3 du véhicule qui doit être commutée par le commutateur à semi-conducteur 4, piloté par un circuit de contrôle 5 commandé habituellement par une clé de contact, est le plus souvent très élevée.

Par exemple, un transistor à effet de champ de type MOSFET 4 doit être capable de commuter une intensité de 70A sur une charge inductive 2 ayant une inductance de 100µH. Ce qui donne une énergie à absorber par le commutateur 4, au moment de son ouverture, d'au moins 250mJ.

Une première solution connue, montrée sur la **Figure 1a,** est d'utiliser une diode de roue libre 6 connectée en parallèle sur la charge inductive 2. Cette première solution n'est pas acceptable dans le domaine de l'automobile pour des raisons de sûreté de fonctionnement.

Une deuxième solution connue, montrée sur la **Figure 1b,** est d'utiliser une diode Transil 7 (diode de suppression des tensions transitoires) en parallèle sur le commutateur 4. Cette deuxième solution n'est pas non plus acceptable dans le domaine très concurrentiel de l'automobile pour des raisons de coût.

Une troisième solution connue, montrée sur la **Figure 1c,** est d'utiliser le transistor MOSFET 4 en mode avalanche pour limiter la surtension à ses bornes. Pour des raisons de fiabilité, cette troisième solution n'est généralement pas retenue.

Une quatrième solution connue, montrée sur la **Figure 1d,** est de mettre en oeuvre un circuit de contrôle 5 comprenant un circuit de clampage actif 8 qui fait passer le transistor à effet de champ 5 en mode linéaire quand une surtension aux bornes de la charge inductive 2 atteint un niveau prédéterminé en fonction d'une tension de référence d'une diode Zener 9.

Cette quatrième solution est la meilleure, car le composant de puissance 4 est utilisé au maximum de ses capacités, sans surcoût inutile. Un seul composant 4 effectue deux opérations:

- la commutation de la charge en mode commuté;
- la dissipation de l'énergie de démagnétisation de la charge inductive 2 en mode linéaire.

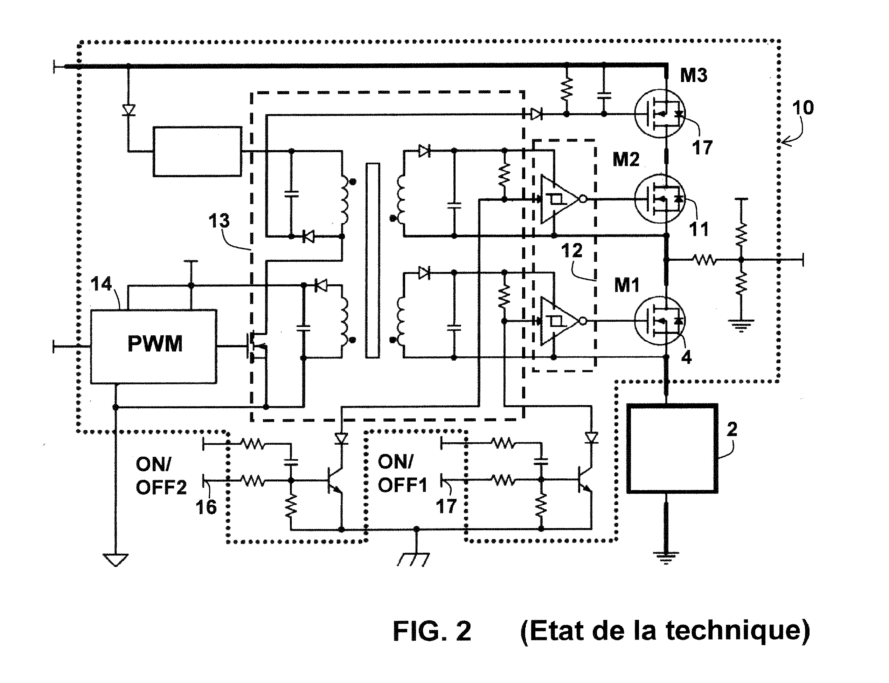

Les relais statiques 1, 10 utilisés dans les véhicules automobiles, comprennent généralement un deuxième commutateur 10 réalisant une fonction d'anti-démarrage monté en série avec le premier 4 dans le circuit d'alimentation du démarreur 2, comme le montre l'exemple de la **Figure 2.**

L'homme de métier identifiera facilement sur ce schéma les premier et second transistors à effet de champ de type MOSFET 4, 11, ainsi leur circuit de pilotage 12 alimenté par une alimentation flottante 13 à découpage 14 et commandé à partir de signaux binaires Marche/Arrêt extérieurs sur les entrées 15, 16 correspondantes.

Le troisième transistor à effet de champ 17 est une simple protection contre les inversions du sens de branchement de la batterie 3.

Dans ce relais statique 10 de l'état de la technique, le premier commutateur 4 sert de contact d'ouverture et de fermeture, et exécute également la démagnétisation de la charge inductive 2, tandis que le deuxième 11 est utilisé uniquement en interrupteur de sécurité, placé en série avec le premier 4, et n'effectue aucune opération de démagnétisation.

Ce qui signifie que le premier commutateur 4 est seul à supporter toutes les contraintes, c'est-à-dire l'échauffement en mode passant (commuté) ainsi que l'échauffement en mode linéaire, comme composant du circuit de clampage actif 8.

Le fait qu'un seul commutateur 4 soit chargé d'effectuer la démagnétisation lui impose une charge de travail et un coût importants, alors que le deuxième commutateur 11 pourrait être mis à contribution gratuitement, puisque sa présence est de toutes manières nécessaire pour des questions de sécurité.

De plus, le commutateur 4 effectuant l'opération de démagnétisation doit supporter des tensions drain-source $V_{DS}$ égales à la somme de la tension Vbatt de la batterie 3 du véhicule et de la tension de démagnétisation $V_{STARTER}$ de la charge inductive 2 à démagnétiser.

Ce qui oblige à augmenter inconsidérément la tension de claquage de ce composant 4, et donc réduire ses performances en termes de résistance (Rdson) à l'état passant.

Ou alors à accepter alternativement de « faire durer » l'opération de démagnétisation, alternative qui présente l'inconvénient d'être rapidement limitée par la menace de destruction du composant 4 par emballement thermique en mode linéaire (dans le clampage actif, le composant 4 fonctionne en mode linéaire).

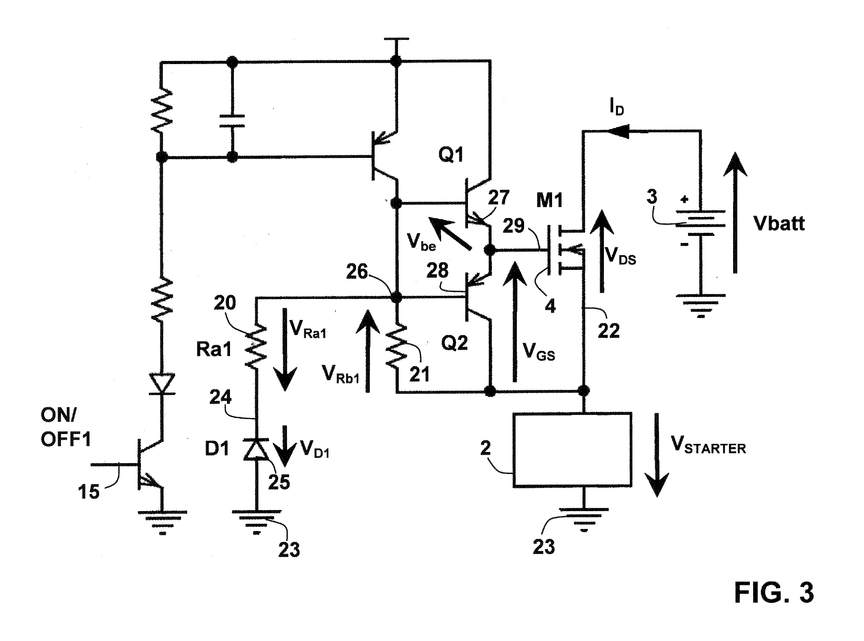

Les modes de réalisation préférés du relais statique 18, 19 selon l'invention, montrés sur les **Figures 3, 4 et 5,** sont basés sur l'utilisation de deux commutateurs 4, 11, formés ici par des transistors MOSFET de puissance, qui travaille en mode linéaire pour répartir les contraintes de l'opération de démagnétisation dans un relais statique 18, 19 selon l'invention.

On notera ici que le fait d'assurer la démagnétisation avec deux transistors

MOSFET, conformément à l'invention, offre l'avantage de pouvoir augmenter de manière importante la tension de démagnétisation et corrélativement de réduire considérablement le temps de démagnétisation. Il devient alors possible, compte-tenu des faibles durées de démagnétisation, d'utiliser des transistors MOSFET à grande transconductance (avec une résistance en conduction Rdson très faible), transistors qui sont connus pour être instables thermiquement sur des durées plus longues telles que celles obtenues avec le circuit de la technique antérieure de la **Figure 2.** Les performances du circuit selon l'invention se trouvent donc améliorées par cette possibilité d'utiliser des transistors à faible résistance Rdson.

En référence plus particulièrement à la **Figure 3,** le circuit de clampage actif 8 selon l'invention comprend un premier pont diviseur de tension formé par une première résistance 20 et une seconde résistance 21. Une première extrémité de ce premier pont 20, 21 est connectée à une première source 22 du premier commutateur 4 qui alimente la charge inductive 2 reliée à une masse 23.

Une seconde extrémité 24 de ce premier pont diviseur de tension 20, 21 est connectée à une première diode 25 reliée à cette masse 23.

Un premier point milieu 26 de ce premier pont diviseur de tension 20, 21 est relié à des premières bases 26 communes de premiers transistors bipolaires complémentaires 27, 28, dont les premiers émetteurs communs sont reliés à une première grille 29 du premier commutateur 4.

On voit ici que, quand le circuit de clampage actif 8 entre en action, c'est-à-dire au moment ou le premier commutateur 4 tente de s'ouvrir, après avoir reçu une commande "Arrêt" en ce sens sur l'entrée appropriée 15 du relais statique 18, 19, la tension de démagnétisation $V_{STARTER}$ aux bornes de la charge inductive 2 monte à $V_{D1} + V_{Ra1} + V_{Rb1}$, $V_{D1}$, $V_{Ra1}$, $V_{Rb1}$, étant respectivement une tension de coude de la première diode 25, et les tensions aux bornes des première et seconde résistances 20, 21 du premier pont diviseur de tension 20, 21.

Or, en mode linéaire, il existe pour le premier MOSFET 4 une relation connue entre sa tension grille- source $V_{GS}$ et une intensité d'un courant de drain $I_D$ qui montre que $V_{GS}$ est relativement peu dépendant de $I_D$, avec les transistors MOSFET modernes à forte transconductance.

Par conséquent, on peu dire que $V_{GS}$ est quasi constant, et un peu au-dessus d'une tension de seuil $V_{GSth}$.

Donc $V_{GS} + V_{be}$ l'est aussi, puisque $V_{be}$, tension base- émetteur des premiers transistors bipolaires 27, 28 est très faible devant $V_{GS}$, et relativement peu variable elle aussi.

Ce qui veut dire que la seconde résistance 21 est polarisée sous une tension à peu près constante, généralement de l'ordre de 4V, mais qui dépend de la température des composants 4, 27.

Il suffit alors de fixer un rapport $R_{a1}/R_{b1}$ des première et seconde résistances électriques $R_{a1}$ et $R_{b1}$ du premier pont diviseur de tension 20, 21 pour décider sous quelle tension approximative s'effectuera la démagnétisation de la charge 2, en négligeant en général $V_D$.

On notera qu'une tension de claquage (BVdss) du premier MOSFET 4 devra toujours être supérieure à Vbatt + $V_{STARTER}$, pour éviter à ce dernier de passer en avalanche.

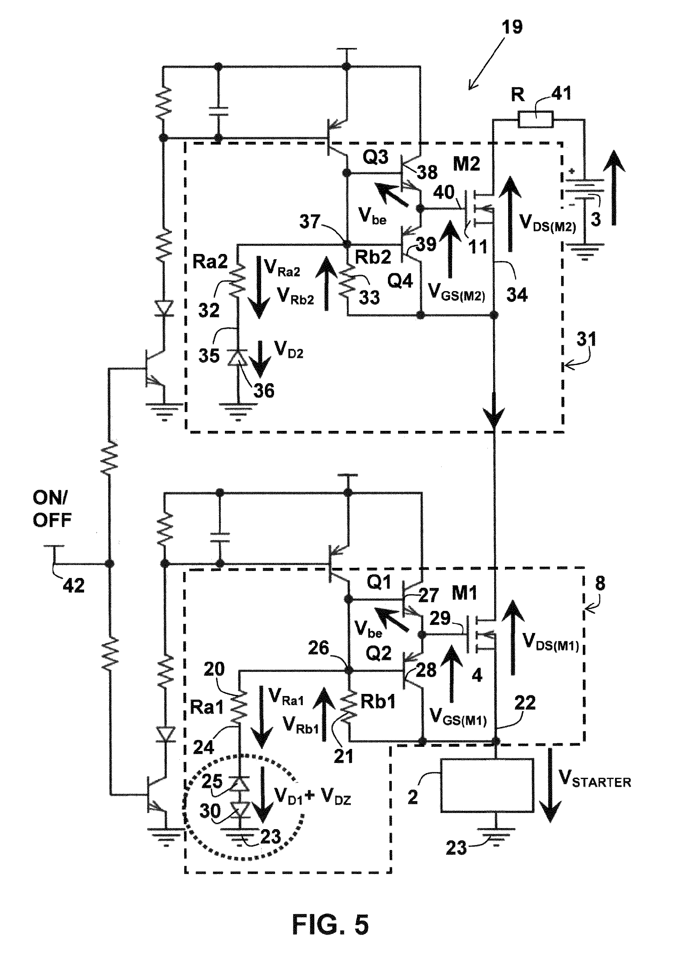

Dans une variante du circuit de clamping actif 8, utilisée dans la variante du relais statique 19 selon l'invention montrée sur la **Figure 5,** une diode Zener 30 est ajoutée en série avec la première diode 25, et montée tête-bêche. Ceci permet de mieux stabiliser le point de fonctionnement du montage, qui devient beaucoup moins dépendant des caractéristiques $V_{be}$ et $V_{GSth}$. Le courant de polarisation de la diode Zener 30 est de l'ordre de quelques mA pour assurer son bon fonctionnement.

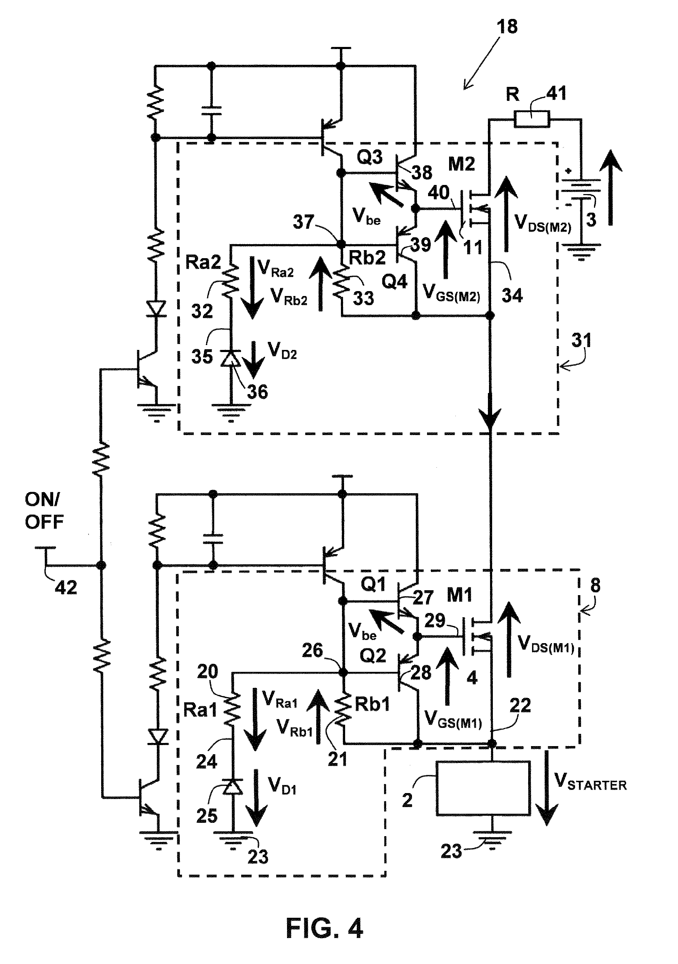

La **Figure 4** montre un relais statique 15 selon l'invention mettant en oeuvre deux exemplaires du circuit de clampage actif 8 montré sur la **Figure 3;** de la sorte le second commutateur 11 participe à l'opération de démagnétisation de la charge inductive 2.

Le second circuit de clampage actif 31 comprend un second pont diviseur de tension formé par une autre première résistance et une autre seconde résistance 33. Une première borne de ce second pont 32, 33 est connectée à une seconde source 34 du second commutateur 11 connectée à un premier drain du premier commutateur 4.

Une seconde borne 35 de ce second pont diviseur de tension 32, 33 est connectée à une seconde diode 36 reliée à la masse 23.

Un second point milieu 37 de ce second pont diviseur de tension 32, 33 est relié à des secondes bases communes de seconds transistors bipolaires complémentaires 38, 39, dont les seconds émetteurs communs sont reliés à une seconde grille 40 du second commutateur 11.

Le concepteur pourra s'aider du formulaire suivant pour réaliser un relais statique 18 selon l'invention répondant à ses besoins:

$$V_{STARTER} = V_{D1} + \frac{1}{k1} \cdot \left( V_{GSth(M1)} + V_{be(Q1-2)} + \frac{I_D}{g_{(M1)}} \right)$$

$$V_{DS(M2)} = Vbatt - R.I_D + V_{D2} + \frac{1}{k2} \cdot \left( V_{GSth(M2)} + V_{be(Q3\text{-}4)} + \frac{I_D}{g_{(M2)}} \right)$$

$$V_{DS(M1)} = V_{D1} - V_{D2} + \frac{1}{k1} \cdot \left( V_{GSth(M1)} + V_{be(Q1\text{-}2)} + \frac{I_D}{g_{(M1)}} \right)$$

avec:

$$- \frac{1}{k2} \cdot \left( V_{GSth(M2)} + V_{be(Q3\text{-}4)} + \frac{I_D}{g_{(M2)}} \right)$$

- $V_{STARTER}$ la tension de démagnétisation de la charge inductive 2;
- $V_{DS(M1)}$ et $V_{DS(M2)}$ les tensions drain- source des premier et second MOSFET 4, 11;
- $V_{D1}$ et $V_{D2}$ les tension de coude des première et seconde diodes respectivement;
- $V_{GSth(M1)}$ et $V_{GSth(M2)}$ les tensions de seuil des premier et second MOSFET 4, 11 respectivement;
- $V_{be(1\text{-}2)}$ et $V_{be(3\text{-}4)}$ les tensions émetteur- collecteur des premiers et seconds transistors bipolaires 27, 28, 38, 39 respectivement;
- $g_{(M1)}$ et $g_{(M2)}$ les transconductances des premier et second MOSFET 4, 11 respectivement;
- $I_D$ étant une intensité d'un courant circulant dans la charge inductive 2 et les deux MOSFETs, charge inductive 2 alimentée par la batterie 3 sous une tension Vbatt;
- R étant une résistance électrique parasite du circuit d'alimentation électrique représenté par une résistance de charge 41 ;
- k1 et k2 les rapports Rb1/Ra1 + Rb1) et Rb2/(Ra2 + Rb2) respectivement, Ra1 et Ra2, Rb1 et Rb2 étant les résistances électriques respectivement des premières et secondes résistances 20, 21, 32, 33 des premier et second ponts diviseurs de tension.

Quand les deux commutateurs 4, 11 sont utilisés également pour réaliser une fonction de sécurité, le signal de commande Marche/ Arrêt commandant le relais statique 19 appliqué sur une borne de commande 42 est séparé en deux commandes indépendantes 16, 17.

On voit ici que la tension de démagnétisation $V_{STARTER}$ de la charge inductive 2 est très dépendante du premier MOSFET 4 choisi. Mais généralement, ID/$g_{(M1)}$ et ID/$g_{(M2)}$ peuvent être négligés.

L'idéal est de connaître avec la meilleure précision possible $V_{DS(M1)}$, pour être sûr de ne jamais démagnétiser la charge inductive 2 sous une tension telle que le premier MOSFET 4 passe en avalanche (régime de fonctionnement pas assez fiable), quelque soit le modèle de transistor choisi, et indépendamment de la température.

La variante 19 du relais statique selon l'invention montrée sur la **Figure 5,** dont le premier circuit de clampage actif 8 incorpore une diode Zener 30 permet de rendre la tension de démagnétisation $V_{STARTER}$ de la charge 2 indépendante des caractéristiques du MOSFET 4 choisi.

Les MOSFET 4, 11 sont de même type, ainsi que les transistors bipolaires 27, 28, 38, 39 de façon à simplifier les relations précédentes avec des transconductances ($g_{(M1)}$ et $g_{(M2)}$), des tensions des seuils ($V_{GSth(M1)}$ et $V_{GSth(M2)}$) et des tensions base- émetteur ($V_{be(1\text{-}2)}$ et $V_{be(3\text{-}4)}$) sensiblement identiques.

Alors la tension drain- source aux bornes du premier MOSFET 4 s'écrit:

$$V_{DS(M1)} = \left( V_{DZ} + V_{D1} \right) - V_{D2} + \left( \frac{1}{k1} - \frac{1}{k2} \right) \cdot \left( V_{GSth} + V_{be} + \frac{I_D}{g} \right)$$

avec:

- $V_{GSth}$ la tension de seuil du type de MOSFET 4, 11 choisi;

- $V_{be}$ la tension émetteur- base des transistors bipolaires 27, 28, 38, 38;
- g la transconductance du type de MOSFET 4, 11 choisi ;
- $V_{DZ}$ la tension Zener de la diode Zener 30;

En choisissant les rapports des premier et second ponts diviseurs de tension égaux à un même rapport k (k1 = k2 = k), on rend la tension drain- source aux bornes du premier MOSFET 4 sensiblement égale à la tension Zener de la diode Zener 30, c'est-à-dire sensiblement constante: $V_{DS(M21)} \approx V_{DZ}$

La répartition des contraintes en mode linéaire entre les premier et second MOSFET 4, 11 permet de calculer le rapport k optimum à partir de l'expression de la tension drain-source aux bornes du second MOSFET 11 rendue égale à celle aux bornes du premier MOSFET 4, c'est-à-dire sensiblement égale à la tension Zener:

$$V_{DS(M2)} = Vbatt_{Max} - R.I_{D(Max)} + V_{D2} + \frac{1}{k} \cdot \left( V_{GSth} + V_{be} + \frac{I_{D(Max)}}{g} \right) = V_{DZ}$$

$$k = \frac{V_{GSth} + V_{be} + \dfrac{I_{D(Max)}}{g}}{V_{DZ} + R.I_{D(Max)} - Vbatt_{Max} - V_{D2}}$$

Soit:

en choisissant des valeurs de l'intensité drain- source $I_{D(Max)}$ et de la tension de batterie 3 $Vbatt_{Max}$ maximales, c'est-à-dire correspondant au pire cas.

Si la tension Zener est choisie suffisamment élevée (par exemple 27V), la tension de démagnétisation de la charge 2 devient constante et quasi indépendante du MOSFET 4, 11 choisi, à condition que k soit petit devant 1.

$$V_{STARTER} = (V_{DZ} + V_{D1}) + \frac{1}{k} \cdot \left( V_{GSth} + V_{be} + \frac{I_D}{g} \right)$$

De plus, la contrainte en tension drain-source sur le premier MOSFET 4 est connue et constante car elle ne dépend plus que de la tension Zener $D_Z$ choisie pour la diode Zener 30, indépendamment de tout le reste: $V_{DS(M1)} \approx V_{.DZ}$

Comme il va de soi l'invention ne se limite pas aux seuls modes de réalisation préférentiels décrits ci-dessus.

Une description générale analogue pourrait également porter sur des types différents de commutateur à semi-conducteur de puissance 4, 11, notamment des composants de type IGBT ("Insulated Gâte Bipolar Transistor" en terminologie anglaise, c'est-à-dire "transistor bipolaire à grille isolée).

L'invention embrasse donc toutes les variantes possibles de réalisation dans la mesure où ces variantes restent dans le cadre défini par les revendications ci-après.

## Revendications

1. Relais statique (1, 10, 18, 19) de commande d'un démarreur électrique (2) de véhicule automobile du type de ceux comprenant en série dans un circuit d'alimentation électrique dudit démarreur (2), formant charge inductive (2), un premier commutateur à semi-conducteur de puissance de type MOSFET (4) et au moins un second commutateur à semi-conducteur de puissance de type MOSFET (11), ledit premier commutateur (4) et ledit second commutateur (11) effectuant une opération de commutation et ledit premier commutateur (4) effectuant en outre une opération de démagnétisation de ladite charge inductive (2) et ledit second commutateur (11) ayant en outre une fonction de sécurité, **caractérisé en ce que** ledit second commutateur (11) effectue en outre ladite opération de démagnétisation, ledit premier commutateur (4) effectuant ladite opération de démagnétisation au moyen d'un premier circuit de clampage actif (8) et ledit second commutateur (11) effectuant ladite opération de démagnétisation au moyen d'un second circuit de clampage actif (31), et ledit premier circuit de clampage actif (8) et ledit second circuit de clampage actif (31) comprennant respectivement un premier pont diviseur de tension (20, 21) et un second pont diviseur de tension (32, 33) déterminant une tension de démagnétisation ($V_{STARTER}$) de ladite charge inductive (2), et **en ce que**

une première extrémité (22) dudit premier pont diviseur de tension (20, 21) est reliée à une première source (22) dudit premier commutateur (4) alimentant ladite charge inductive (2) par rapport à une masse (23), et une seconde extrémité (24) dudit premier pont diviseur de tension (20, 21) est reliée à une première diode (25) reliée à ladite masse (23), un premier point milieu (26) dudit premier pont diviseur de tension (20, 21) étant relié à des premières bases communes (26) de premiers transistors bipolaires complémentaires (27, 28) ayant des premiers émetteurs communs (29) connectés à une première grille (29) dudit premier commutateur (4).

2. Relais statique (18, 19) de commande d'un démarreur électrique (2) de véhicule automobile selon la revendication 1, **caractérisé en ce qu'**une première borne (34) dudit second pont diviseur de tension (32, 33) est reliée à une seconde source (34) dudit second commutateur (11) connectée à un premier drain (34) dudit premier commutateur (4), et une seconde borne (35) dudit second pont diviseur de tension (32, 33) est reliée à une seconde diode (36) reliée à ladite masse (23), un second point milieu (37) dudit second pont diviseur de tension (32, 33) étant relié à des secondes bases communes (37) de seconds transistors bipolaires complémentaires (38, 39) ayant des seconds émetteurs communs (40) connectés à une seconde grille (40) dudit second commutateur (11).

3. Relais statique (18, 19) de commande d'un démarreur électrique (2) de véhicule automobile selon la revendication 2, **caractérisé en ce que** ladite première diode (25) est en outre reliée à ladite masse (23) par une diode Zener (30) montée tête-bêche en série.

4. Relais statique (18, 19) de commande d'un démarreur électrique (2) de véhicule automobile selon la revendication 3, **caractérisé en ce que** ledit premier pont diviseur de tension (20, 21) et ledit second pont diviseur de tension (32, 33) présentent un même rapport prédéterminé.

5. Relais statique (18, 19) de commande d'un démarreur électrique (2) de véhicule automobile selon la revendication 4, **caractérisé en ce que** ledit premier commutateur (4) et ledit second commutateur (11) présentant une même tension de seuil prédéterminée et une même transconductance prédéterminée, lesdits premiers transistors bipolaires complémentaires (27, 28) et lesdits seconds transistors bipolaires complémentaires (38, 39) présentant une même tension émetteur- collecteur prédéterminée ($V_{be}$), ledit rapport prédéterminé est donné par la relation:

$$k = \frac{V_{GSth} + V_{be} + \dfrac{I_{D(Max)}}{g}}{V_{DZ} + R.I_{D(Max)} - Vbatt_{Max} - V_{D2}}$$

- $V_{GSth}$ étant ladite tension de seuil prédéterminée;
- $V_{be}$ étant ladite tension émetteur-base prédéterminée;
- $g$ étant ladite transconductance prédéterminée;
- $V_{DZ}$ étant une tension Zener de ladite diode Zener (30);
- $V_{D2}$ étant une tension de coude de ladite seconde diode (36);
- $I_{D(Max)}$ étant une intensité maximale d'un courant circulant dans ladite charge inductive (2) alimentée par une batterie (3) d'une tension maximale égale à $Vbatt_{Max}$;
- R étant une résistance électrique dudit circuit d'alimentation électrique.

6. Démarreur de véhicule automobile **caractérisé en ce qu'**il comprend un relais statique (18, 19) selon l'une quelconque des revendications 1 à 5 précédentes.

FIG. 1a

FIG. 1b

FIG. 1c

FIG. 1d

FIG. 2    (Etat de la technique)

FIG. 3

EP 2 991 225 A1

**FIG. 4**

**FIG. 5**

Europäisches
Patentamt

European
Patent Office

Office européen
des brevets

# RAPPORT DE RECHERCHE EUROPEENNE

Numéro de la demande

EP 15 18 0249

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2001/017783 A1 (BRUCKMANN MANFRED [DE] ET AL) 30 août 2001 (2001-08-30) * alinéa [0042] - alinéa [0044]; figures 1, 5 * | 1-6 | INV. H03K17/082 F02N11/08 H03K17/16 |
| A | FR 2 733 648 A1 (CELDUC RELAIS SA [FR]) 31 octobre 1996 (1996-10-31) * abrégé; figure 1 * | 1-6 | |
| A | US 6 148 781 A (BOEGNER KARLHEINZ [DE] ET AL) 21 novembre 2000 (2000-11-21) * abrégé; figure 9 * | 1-6 | |
| A | EP 0 987 434 A1 (VALEO EQUIP ELECTR MOTEUR [FR]) 22 mars 2000 (2000-03-22) * abrégé; figure 1 * | 1-6 | |
| A | DE 44 28 675 A1 (SIEMENS AG [DE]) 15 février 1996 (1996-02-15) * figure 6 * | 1-6 | |
| A | US 2010/117707 A1 (OZALEVLI ERHAN [US] ET AL) 13 mai 2010 (2010-05-13) * figure 2 * | 1-6 | DOMAINES TECHNIQUES RECHERCHES (IPC)  F02N H02H H02M H03K |
| A | US 2008/084642 A1 (KATO SHUJI [JP] ET AL) 10 avril 2008 (2008-04-10) * figure 6 * | 1-6 | |

Le présent rapport a été établi pour toutes les revendications

| Lieu de la recherche | Date d'achèvement de la recherche | Examinateur |
|---|---|---|
| La Haye | 7 janvier 2016 | Loiseau, Ludovic |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 15 18 0249

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-01-2016

| Document brevet cité au rapport de recherche | | Date de publication | Membre(s) de la famille de brevet(s) | | Date de publication |
|---|---|---|---|---|---|
| US 2001017783 | A1 | 30-08-2001 | DE | 19838389 C1 | 09-03-2000 |
| | | | DE | 59903575 D1 | 09-01-2003 |
| | | | EP | 1110035 A2 | 27-06-2001 |
| | | | NO | 20010945 A | 24-04-2001 |
| | | | US | 2001017783 A1 | 30-08-2001 |
| | | | WO | 0011407 A2 | 02-03-2000 |
| FR 2733648 | A1 | 31-10-1996 | AUCUN | | |
| US 6148781 | A | 21-11-2000 | BR | 9607600 A | 09-06-1998 |
| | | | CN | 1172520 A | 04-02-1998 |
| | | | EP | 0808420 A1 | 26-11-1997 |
| | | | JP | H11502579 A | 02-03-1999 |
| | | | US | 6148781 A | 21-11-2000 |
| | | | WO | 9623970 A1 | 08-08-1996 |
| EP 0987434 | A1 | 22-03-2000 | BR | 9904198 A | 01-08-2000 |
| | | | DE | 69923738 D1 | 24-03-2005 |
| | | | DE | 69923738 T2 | 30-03-2006 |
| | | | EP | 0987434 A1 | 22-03-2000 |
| | | | FR | 2783371 A1 | 17-03-2000 |
| | | | JP | 2000097137 A | 04-04-2000 |
| | | | KR | 20000023172 A | 25-04-2000 |
| | | | US | 6456034 B1 | 24-09-2002 |
| DE 4428675 | A1 | 15-02-1996 | AUCUN | | |
| US 2010117707 | A1 | 13-05-2010 | AUCUN | | |
| US 2008084642 | A1 | 10-04-2008 | CN | 101154883 A | 02-04-2008 |
| | | | JP | 4432953 B2 | 17-03-2010 |
| | | | JP | 2008086096 A | 10-04-2008 |
| | | | KR | 20080028807 A | 01-04-2008 |
| | | | US | 2008084642 A1 | 10-04-2008 |
| | | | US | 2010321847 A1 | 23-12-2010 |

EPO FORM P0460

Pour tout renseignement concernant cette annexe : voir Journal Officiel de l'Office européen des brevets, No.12/82

**EP 2 991 225 A1**

## RÉFÉRENCES CITÉES DANS LA DESCRIPTION

**Documents brevets cités dans la description**

- WO 200503177 A